# EUROPEAN PATENT APPLICATION

(11) **EP 4 404 409 A1**
(43) Date of publication of application: **24.07.2024**
(21) Application number: 23217505.9
(22) Date of filing: 18.12.2023
(51) Int. Cl.: H02J 3/00, H02J 3/28, H02J 3/38

(54) **A METHOD AND APPARATUS FOR MANAGEMENT OF POWER IN AN INDUSTRIAL GAS PRODUCTION FACILITY**

(30) Priority: 21.12.2022 US 202218085675
(71) Applicant: Air Products and Chemicals, Inc., Allentown, PA 18106-5500 (US)
(72) Inventor: Espie, David M, 19446 Lansdale (US); Wilson, Graeme Richard, KT5 8JY Surbiton (GB); Wright, Kevin, RG42 4UR Binfield (GB); Hughes, David, SW20 8HW London (GB); Gilles van Luijk, Nicolaas, 2553EH The Hague (NL)
(74) Representative: Beck Greener LLP

(57) **Abstract**

A method of managing power in a power microgrid, the method comprising: generating, by the facility controller, time-dependent predicted power demand data representative of at least a predicted power demand of the industrial gas production facility for a predetermined time period; utilizing, by the power controller, the predicted power demand data to generate control set point values for controlling a generated power output of the one or more renewable power sources and for controlling a flow of electrical power to or from the energy storage resources, the control set point values being selected to adjust the available power as a function of time for the predetermined time period to correspond to the demanded power for the predetermined time period; and sending one or more control signals comprising the control set point values to the one or more renewable power sources and to the one or more energy storage resources.

## Description

The present invention relates to a method and system for management of power in an industrial gas production facility. More particularly, the present invention relates to a method and system for management of power in an industrial gas production facility utilizing a variable input power resource such as a renewable power source.

An industrial gas production facility may comprise one or more process plants which produce, or are involved in the production of, gases. In non-limiting examples, these gases may comprise: industrial gases, commercial gases, medical gases, inorganic gases, organic gases, fuel gases and green fuel gases either in gaseous, liquified or compressed form.

There is considerable interest in methods and systems for utilising renewable energy sources for powering industrial gas plants and industrial gas production facilities. However, a significant drawback of the use of renewable energy sources such as wind, solar and tidal power is the natural variability and transient nature of such energy sources.

Since the available renewable power is not demand-led and depends on the availability of the natural resources (e.g. wind, sunlight, tides), it can be challenging to match the available power to the required power for the industrial gas production facility. This is relevant in both power-limited and demand-limited scenarios.

In general, a constant or substantially constant power supply is preferred for an industrial gas plant or industrial gas production facility. Therefore, in power-limited scenarios, the variable and intermittent nature of wind, solar and/or tidal power is problematic and renders it difficult to ensure maximum utilisation of an industrial gas plant or industrial gas production facility utilizing such power sources whilst also avoiding shutdowns and other undesirable events due resulting from temporarily insufficient power.

A further challenge is in demand-limited scenarios, where excess power above demand is available and must be handled appropriately to avoid operational issues and even potential damage to the renewable power grid and/or the industrial gas production facility.

Therefore, there exists a need in the art to provide more effective power control integration methods and arrangements to address these issues.

The following introduces a selection of concepts in a simplified form in order to provide a foundational understanding of some aspects of the present disclosure. The following is not an extensive overview of the disclosure, and is not intended to identify key or critical elements of the disclosure or to delineate the scope of the disclosure. The following merely summarizes some of the concepts of the disclosure as a prelude to the more detailed description provided thereafter.

Several preferred aspects of the methods and systems according to the present invention are outlined below.

Aspect 1: A method of managing power in a power microgrid configured to supply electrical power to an industrial gas production facility comprising a facility controller and one or more industrial gas plants, the power microgrid comprising a power controller, one or more renewable power sources and one or more energy storage resources, the method being executed by at least one hardware processor and comprising: a) generating, by the facility controller, time-dependent predicted power demand data representative of at least a predicted power demand of the industrial gas production facility for a predetermined time period; b) utilizing, by the power controller, the predicted power demand data to generate control set point values for controlling a generated power output of the one or more renewable power sources and for controlling a flow of electrical power to or from the energy storage resources, the control set point values being selected to adjust the available power as a function of time for the predetermined time period to correspond to the demanded power for the predetermined time period; and c) sending one or more control signals comprising the control set point values to the one or more renewable power sources and to the one or more energy storage resources.

Aspect 2: A method according to aspect 1, wherein the step of generating further comprises:
d) receiving, by the facility controller, time-dependent predicted available power data representative of at least the predicted available power from the power microgrid for the predetermined time period; and e) generating the time-dependent predicted power demand data based at least in part on the time-dependent predicted available power data.

Aspect 3: A method according to aspect 2, wherein steps d) and e) are repeated at discrete time intervals for further predetermined time periods.

Aspect 4: A method according to aspect 2 or 3, wherein, prior to step d), the method further comprises: f) generating, by the power controller, the time-dependent predicted available power data based on historical, real-time and/or predicted time-dependent environmental data associated with the one or more renewable power sources.

Aspect 5: A method according to aspect 4, wherein step f) further comprises generating the time-dependent predicted available power data based on a comparison between measured power generation and predicted power generation by the one or more renewable power sources for a previous predetermined time period.

Aspect 6: A method according to any one of aspects 1 to 5, further comprising, subsequent to step a): g) sending the time-dependent power demand data to the power controller of the power microgrid.

Aspect 7: A method according to aspect 6, wherein step g) is repeated at discrete time intervals.

Aspect 8: A method according to any one of aspects 1 to 7, wherein the time-dependent power demand data is generated based on time-dependent operational characteristic data representative of one or more operational parameters of the one or more industrial gas plants and/or one or more constraints for the operational parameters of each industrial gas plant.

Aspect 9: A method according to any one of aspects 1 to 8, wherein the one or more energy storage resources comprise one or more of: a battery energy storage system; a compressed air energy storage system; and a liquid air energy storage system.

Aspect 10: A method according to any one of aspects 1 to 9, wherein the control set point values are selected to adjust the available power as a function of time for the predetermined time period to minimize the difference between the generated power and the demanded power for the predetermined time period.

Aspect 11: A control system operable to manage power in a power microgrid configured to supply electrical power to an industrial gas production facility, the power microgrid comprising one or more renewable power sources and one or more energy storage resources, and the industrial gas production facility comprising one or more industrial gas plants, the system comprising a power controller associated with the power microgrid and a facility controller associated with the industrial gas production facility, the system comprising at least one hardware processor operable to perform the steps of: a) generating, by the facility controller, time-dependent predicted power demand data representative of at least a predicted power demand of the industrial gas production facility for a predetermined time period; b) utilizing, by the power controller, the predicted power demand data to generate control set point values for controlling a generated power output of the one or more renewable power sources and for controlling a flow of electrical power to or from the energy storage resources, the control set point values being selected to adjust the available power as a function of time for the predetermined time period to correspond to the demanded power for the predetermined time period; and c) sending one or more control signals comprising the control set point values to the one or more renewable power sources and to the one or more energy storage resources.

Aspect 12: A system according to aspect 11, wherein the step of generating further comprises:
d) receiving, by the facility controller, time-dependent predicted available power data representative of at least the predicted available power from the power microgrid for the predetermined time period; and e) generating the time-dependent predicted power demand data based at least in part on the time-dependent predicted available power data.

Aspect 13: A system according to aspect 12, wherein steps d) and e) are repeated at discrete time intervals for further predetermined time periods.

Aspect 14: A system according to aspect 12 or 13, wherein, prior to step d), the method further comprises: f) generating, by the power controller, the time-dependent predicted available power data based on historical, real-time and/or predicted time-dependent environmental data associated with the one or more renewable power sources.

Aspect 15: A system according to aspect 14, wherein step f) further comprises generating the time-dependent predicted available power data based on a comparison between measured power generation and predicted power generation by the one or more renewable power sources for a previous predetermined time period.

Aspect 16: A system according to any one of aspects 11 to 15, further comprising, subsequent to step a): g) sending the time-dependent power demand data to the power controller of the power microgrid.

Aspect 17: A system according to claim 16, wherein step g) is repeated at discrete time intervals.

Aspect 18: A system according to any one of aspects 11 to 17, wherein the time-dependent power demand data is generated based on time-dependent operational characteristic data representative of one or more operational parameters of the one or more industrial gas plants and/or one or more constraints for the operational parameters of each industrial gas plant.

Aspect 19: A system according to any one of aspects 11 to 18, wherein the one or more energy storage resources comprise one or more of: a battery energy storage system; a compressed air energy storage system; and a liquid air energy storage system.

Aspect 20: A non-transitory computer readable storage medium storing a program of instructions executable by a machine to perform a method of managing power in a power microgrid configured to supply electrical power to an industrial gas production facility comprising a facility controller and one or more industrial gas plants, the power microgrid comprising a power controller, one or more renewable power sources and one or more energy storage resources, the method being executed by at least one hardware processor and comprising: a) generating, by the facility controller, time-dependent predicted power demand data representative of at least a predicted power demand of the industrial gas production facility for a predetermined time period; b) utilizing, by the power controller, the predicted power demand data to generate control set point values for controlling a generated power output of the one or more renewable power sources and for controlling a flow of electrical power to or from the energy storage resources, the control set point values being selected to adjust the available power as a function of time for the predetermined time period to correspond to the demanded power for the predetermined time period; and c) sending one or more control signals comprising the control set point values to the one or more renewable power sources and to the one or more energy storage resources.

Embodiments of the present invention will now be described by example only and with reference to the figures in which:
FIGURE 1 is a schematic diagram of an industrial gas production facility;
FIGURE 2 is a schematic diagram of a power microgrid control system;
FIGURE 3 is a schematic diagram of a facility control system;
FIGURE 4 is a schematic diagram showing communication between the power microgrid control system and the facility control system; and
FIGURE 5 is a flow diagram of a method of the present invention.

Embodiments of the present disclosure and their advantages are best understood by referring to the detailed description that follows. It should be appreciated that like reference numbers are used to identify like elements illustrated in one or more of the figures, wherein showings therein are for purposes of illustrating embodiments of the present disclosure and not for purposes of limiting the same.

Various examples and embodiments of the present disclosure will now be described. The following description provides specific details for a thorough understanding and enabling description of these examples. One of ordinary skill in the relevant art will understand, however, that one or more embodiments described herein may be practiced without many of these details. Likewise, one skilled in the relevant art will also understand that one or more embodiments of the present disclosure can include other features and/or functions not described in detail herein. Additionally, some well-known structures or functions may not be shown or described in detail below, so as to avoid unnecessarily obscuring the relevant description.

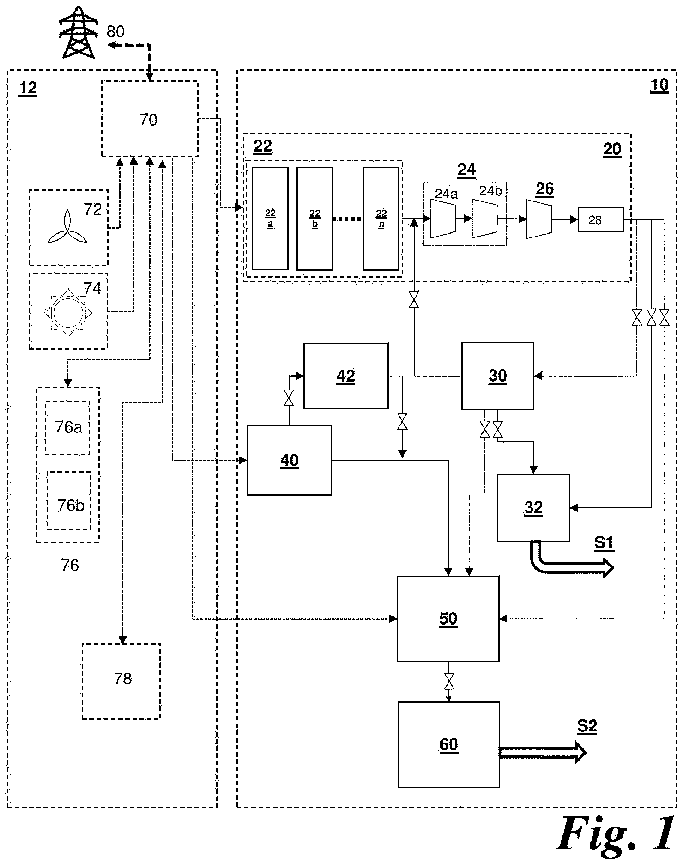

The components of an exemplary industrial gas production facility and associated power microgrid will now be described with reference to Figure 1. The method and system of the present invention is operable to manage power distribution between the power microgrid and the industrial gas production facility through feedback of power information from the industrial gas production facility to the one or more controllers of the power microgrid.

Figure 1 shows a schematic diagram of an exemplary industrial gas production facility 10 and power microgrid 12.

In this embodiment, the industrial gas production facility 10 comprises an ammonia industrial gas production facility 10. However, this is to be taken as exemplary and non-limiting. Other types of industrial gas production facilities may be utilized with the disclosed embodiments of the present invention; for example, a hydrogen production plant, a nitrogen production plant or other industrial gas production facilities.

The industrial gas production facility 10 comprises a hydrogen production plant 20, a hydrogen storage unit 30, a hydrogen liquefier 32, an Air Separation Unit (ASU) 40, an ammonia synthesis plant 50 and an ammonia storage unit 60. The hydrogen liquefier 32 is connected to an external supply chain S1 for onward distribution of liquid hydrogen. The ammonia storage unit 60 is connected to an external supply chain S2 for onward distribution of ammonia.

The power microgrid 12 comprises power resources in in the form of a main microgrid bus 70, renewable power sources 72, 74, energy storage resources 76, a static synchronous compensator (STATCOM) 78 and a connection to an external power grid 80.

### INDUSTRIAL GAS PRODUCTION FACILITY STRUCTURE

The industrial gas production components of the industrial gas production facility 10 will now be described in detail.

### HYDROGEN PRODUCTION PLANT 20

The hydrogen production plant 20 is operable to electrolyse water to form hydrogen and oxygen. Any suitable source of water may be used. However, in embodiments in which sea water is used to produce the water for the electrolysis, the apparatus would further comprise at least one desalination and demineralisation plant for processing the sea water.

The hydrogen production plant 20 comprises a plurality of electrolysis units 22a, 22b ... 22n or electrolysis cells. Each unit or cell may be referred to as an "electrolyser" 22a, 22b ... 22n. Any number of electrolysers may be provided. In embodiments, around 100 may be provided. The electrolysers may enable the hydrogen production plant 20 to have a total capacity of at least 1 GW. In embodiments, the capacity may be in excess of 2 GW; for example, 2.2 GW. However, the ultimate capacity of the hydrogen production plant 20 is limited only by practical considerations such as power supply.

Any suitable type of electrolyser may be used. In embodiments, the plurality of electrolysers usually consists of a multiplicity of individual cells combined into "modules" that also include process equipment such as pumps, coolers, and/or separators. Hundreds of cells may be used and may be grouped in separate buildings. Each module typically has a maximum capacity greater than 10 MW, although this is not intended to be limiting.

Any suitable type of electrolyser may be used. Generally, three conventional types of electrolysers are utilized - alkaline electrolysers; PEM electrolysers; and solid oxide electrolysers. Any of these types may be used with the present invention.

Alkaline electrolysers transport hydroxide ions (OH⁻) through the electrolyte from the cathode to the anode with hydrogen being generated on the cathode side. Commonly, a liquid alkaline solution of sodium hydroxide or potassium hydroxide is used as the electrolyte.

A PEM electrolyser utilizes a solid plastics material as an electrolyte, and water reacts at an anode to form oxygen and positively charged hydrogen ions. The electrons flow through an external circuit and the hydrogen ions selectively move across the PEM to the cathode. At the cathode, hydrogen ions combine with electrons from the external circuit to form hydrogen gas.

Solid oxide electrolysers use a solid ceramic material as the electrolyte that selectively conducts negatively charged oxygen ions (O²⁻) at elevated temperatures. Water at the cathode combines with electrons from the external circuit to form hydrogen gas and negatively charged oxygen ions. The oxygen ions pass through the solid ceramic membrane and react at the anode to form oxygen gas and generate electrons for the external circuit.

The electrolysers may be arranged in any suitable group. For example, they may be arranged in parallel.

Hydrogen is produced at about atmospheric pressure by the hydrogen production plant 20. A stream of hydrogen so generated is removed from the electrolysers at a slightly elevated pressure.

In embodiments, the hydrogen production plant 20 further comprises hydrogen compression and purification stages.

In embodiments, the compression stage comprises a multistage compression system having two sections 24, 26. The first section 24 comprises a low pressure (LP) section in which hydrogen gas is compressed from a first feed pressure from the electrolysers to a second intermediate pressure greater than the first feed pressure.

The second section comprises a medium pressure (MP) section 26 in which the hydrogen gas is compressed from the second intermediate pressure to a third final pressure greater than the second pressure. The third pressure is selected as required for any downstream process(es).

In the non-limiting embodiment shown in Figure 1, the first (LP) section 24 has two compressor stages 24a, 24b. However, any suitable number may be used. For example, the LP section 24 may have a single compressor or may have a plurality of compressors.

As shown in the non-limiting embodiment of Figure 1, the second (MP) section 26 is shown as a single compressor arrangement for brevity. However, any suitable number of parallel trains and/or stages of compression may be provided as required. For example, a plurality of trains may be provided in parallel, with each train comprising a plurality of compression stages.

The compressors forming part of the first (LP) 24 and second (MP) 26 compression sections may take any suitable form. The person skilled in the art would readily be aware of the form, number and capacity of these compressors. For example, for a total electrolyser capacity of 1 GW, 2 to 4 compressors would typically be required. 5 or more may be required for total electrolyser capacity of 2GW.

The compressors used may also be selected as appropriate for the operational capacity and type of gas production plant. For example, for hydrogen applications, the LP section 24 may comprise one or more centrifugal compressors, whilst the MR section 26 may comprise one or more reciprocating compressors. However, this is not intended to be limiting and any suitable compression arrangements may be used as appropriate.

In the embodiment of Figure 1, a purification section 28 is provided. The purification section 28 may be required where, for example, any downstream processes require higher purity hydrogen (i.e., with reduced levels of water and/or oxygen inherently present in the compressed hydrogen gas produced by the electrolysis). However, this need not be the case and this section may be omitted if not required.

If provided, the purification section 28 comprises a "DeOxo" unit operable to remove oxygen. The DeOxo unit operates through the catalytic combustion of hydrogen to produce water compressed hydrogen gas from which Oxygen has been removed.

The purification section 28 may further comprise a drier. In this embodiment, the drier comprises a temperature swing adsorption (TSA) unit to produce dry compressed hydrogen gas for the downstream process(es). However, other suitable drier and/or adsorption technologies may be used here. In embodiments, the drier is downstream of the DeOxo unit.

A downstream processing unit may be any unit that utilises hydrogen gas as a feedstock. In embodiments, the downstream processing unit is or includes an ammonia synthesis plant.

### HYDROGEN STORAGE UNIT 30

Hydrogen may be stored in the hydrogen storage unit 30. The storage unit 30 may comprise of a plurality of short-term and longer-term storage options with different sizes, filling/discharge rates, and roundtrip efficiencies.

Typical storage system could include pressure vessels and/or pipe segments connected to a common inlet/outlet header. The pressure vessels may be spheres, for example, to about 25 m in diameter, or "bullets" which are horizontal vessels with large LID ratios (typically up to about 12:1) with diameters up to about 12 m. In certain geographies, underground caverns may be included as storage systems to flatten out the seasonal variations associated with the renewable power.

The hydrogen storage 30 is connected downstream of the hydrogen production plant 20 in a storage loop. An inlet supply line to the hydrogen storage 30 extends from the outlet header of the purification section 28 of the hydrogen production plant 20 to the hydrogen storage 30, and a return supply line extends from the hydrogen storage 30 to the output header downstream of the electrolysers 22 and upstream of the compression sections 24, 26. Valves are located in the inlet and return supply lines to control selectively the flow of gas to/from the hydrogen storage 30.

Hydrogen storage 30 is in general required as a buffer in view of the variability of renewable power. If, for example, the renewable power availability is low (e.g., during hours of darkness or low wind), then it may not be possible to run the electrolysers of the hydrogen production plant 20 at full capacity or potentially at all. In order to maintain a flow of hydrogen to downstream processes, stored hydrogen can be mobilised.

The capacity of hydrogen storage (or indeed storage of any gas) needs to be configured and specified in accordance with practical requirements. Gas storage may take up considerable space within an industrial gas production facility 10 and require significant capital expenditure.

In the context of the present embodiments, stored hydrogen may be used as a reservoir for ammonia synthesis plant 50.

### HYDROGEN LIQUEFIER 32

Additionally or alternatively to the use of hydrogen for ammonia synthesis in the ammonia synthesis plant 50, generated hydrogen may be liquified for onward distribution into a supply network S1.

Typically, hydrogen liquefaction involves some degree of initial compression using a compression system, followed by cryogenic cooling using one or more heat exchangers to around 30K. An expansion step may then take place in an expander. The gas is then passed through a separator before being stored or transferred to the onward supply network S1.

### AIR SEPARATION UNIT 40

In non-limiting embodiments, the nitrogen gas required for ammonia production is produced by cryogenic distillation of air in the air separation unit (ASU) 40. Typically an ASU 40 has various stages operating at different pressures. For example, a high pressure (HP) Column operates at around 10.5 bar g and a low pressure (LP) Column operates at around 5 bar g. Gaseous Nitrogen is produced by the ASU 40 at pressures in excess of 25 bar g. The pressure is then reduced to provide a stream of nitrogen gas in one or more pipes arranged to transport nitrogen to the ammonia synthesis plant 40. However, other Nitrogen sources may be used if required, for example, liquid nitrogen storage 42.

Liquid nitrogen storage unit 42 may comprise any suitable liquid nitrogen storage, Vaporisation and Distribution (LIN SVD) arrangement. The storage unit 42 may comprise a plurality of short-term and longer-term storage options having different sizes, filling/discharge rates, and roundtrip efficiencies.

A typical storage system for liquid nitrogen may comprise a plurality of pressure vessels and/or pipe segments connected to a common inlet/outlet header. The pressure vessels may comprise low pressure flat bottom storage tanks (FBTs). Additionally or alternatively, the pressure vessels may be spheres, for example, to about 25 m in diameter, or "bullets" which are horizontal vessels with large LID ratios (typically up to about 12:1) with diameters up to about 12 m.

As described above in relation to the hydrogen storage resource 30, the nitrogen storage 42 is required to be configured and specified in accordance with practical requirements. Gas storage may take up considerable space within an industrial gas production facility 10 and require significant capital expenditure.

So, whilst in an ideal situation, sufficient gas storage would be provided to ensure that all periods of expected low renewable power could be covered by stored gas resources, physical, practical and capital expenditure constraints place practical limits on the size and capacity of available gas resources. This means that, in a practical context, the finite size of gas resources must be factored in when considering the method and system of the present invention.

Preferably, the nitrogen gas produced by the ASU 40 is compressed by a compressor and cooled to be stored in the nitrogen storage unit 42 in liquid form. However, gaseous nitrogen storage may also be provided. The storage unit 42 may be used as a reservoir for ammonia synthesis plant 50 which may be fed by a connecting pipe.

### AMMONIA SYNTHESIS PLANT 50

The ammonia synthesis plant 50 operates on the Haber-Bosch process and comprises an ammonia loop. An ammonia loop is a single unit equilibrium reactive system which processes the synthesis gases of nitrogen and hydrogen to produce ammonia.

Nitrogen is provided by one or more pipes from the ASU 40 (or storage 42) which, in embodiments, may run continuously to provide nitrogen. Hydrogen is provided from one or more pipes from hydrogen production plant 20 either directly (if it is running based on the availability of the renewable power at given instance) or from the hydrogen storage 30.

Stoichiometric composition of synthesis gas is processed by a syn-gas compressor system (not shown) and the resulting ammonia product is refrigerated by another set of compressors (not shown) and sent to storage 60 if required. The performance of ammonia loop is governed by the equilibrium conversion of the exothermic reaction. The parameters for this will be discussed below.

### POWER MICROGRID STRUCTURE

Electricity for powering the industrial gas production facility 10 is provided by the power microgrid 12. The power microgrid 12 has a main microgrid bus 70. Renewable power sources 72, 74 feed electricity into the main microgrid bus 70 for onward distribution to subsystems of the industrial gas production facility 10. This is shown schematically in Figure 1 through dotted arrows.

The renewable energy sources comprise wind energy sources 72 (via a suitable wind farm comprising a plurality of wind turbines) and/or solar energy sources 74 (via a solar farm comprising a plurality of solar cells) although other forms of renewable energy may also be utilized (for example, tidal or hydroelectric power sources).

To address the intermittency of power supply from renewable sources 72, 74, the industrial gas production facility 10 comprises an energy storage resource 76. In embodiments, the energy storage resource 76 is located on-site and forms part of the superstructure of the industrial gas production facility 10, although it may be managed as part of the power microgrid.

The energy storage resource 76 may comprise one or more energy storage devices. In embodiments, the energy storage resource 76 forms part of the industrial gas production facility 10 and is controlled and managed thereby as will be described below.

The energy storage resource 76 may take any suitable form. In embodiments, the energy storage devices may comprise one or more of: a Battery Energy Storage System (BESS) 76a or a Compressed/Liquid Air Energy Systems (CAES or LAES) 76b.

A BESS 76a utilises electrochemical techniques and may comprise one or more of: Lithium-Ion batteries, Lead acid batteries, Zinc Bromine, Sodium Sulphur or Redox Flow batteries. Electro-chemical arrangements such as batteries have advantages in terms of fast charging rates and fast (virtually instantaneous) ramp rates to supply power to cope with a sudden drop in energy supply. However, such devices tend to be of more limited power capacity than other systems. Therefore, they may be better suited for use in situations where, for example, a power shortfall from renewable sources is expected to be temporary or short in duration.

A CAES 76b compresses air and stores the air under a high pressure of around 70 bar. It is usually stored in an underground cavern. When power is required, the compressed air is heated and expanded in an expansion turbine in order to drive a generator.

A LAES 76b comprises an air liquefier to draw air from the environment and compress and cool the air to achieve liquefaction. The liquified air is then stored in an insulated tank until power is required. To convert the liquified air into useable energy, the liquid air is pumped to high pressure and heated through heat exchangers. The resulting high-pressure gas is used to drive a turbine to generate electricity.

CAES and LAES are capable of storing significantly more energy than most BESS 76a systems. However, CAES and LAES have slower ramp rates than electro-chemical storage devices and require longer to store larger quantities of energy. For example, it may take of the order of 5-10 minutes for a compression stage to operate under full load, and 10 - 20 minutes to generate full power on demand. Such storage devices are therefore more appropriate for longer-term storage and for supplying power during long periods of renewable energy shortfall.

Whilst all these elements are shown in Figure 1, this is for illustrative purposes only. The energy storage resource 76 need not comprise each and every described element and may comprise only one or more of the described elements. In addition, the energy resource 76 may comprise additional elements.

Elements 72, 74, 76 feed into the main microgrid bus 70 as shown by the arrows in Figure 1. Element 76 is operable to supply power to the main microgrid bus 70 when demand requires it, and to store energy from the main microgrid bus 70 when demand is low. In other words, the energy storage resource 76 acts to smooth the power delivery to the network in view of the variability of renewable energy sources such as wind 72 and solar 74.

Whilst the above examples of renewable power have been given with regard to wind and solar power, this is not intended to be limiting. For example, other renewable energy sources may be used such as hydro-electric (not shown) and/or tidal power (not shown).

The power microgrid 12 further comprises a static synchronous compensator (STATCOM) 78. A STATCOM is a fast-acting electrical element operable to provide or absorb a reactive current and as a result regulate the voltage at the point of connection to the microgrid bus 70. In examples, STATCOM 78 may utilize voltage source converters (VSCs) having semiconductor valves in a modular configuration.

The main microgrid bus 70 is, as shown in Figure 1, connected to local power grid infrastructure 80. The local grid infrastructure 80 is outside the scope of the power microgrid 12. However, a supply connection may be required as an emergency backup in the event of emergencies or in rare situations where sufficient power from elements 72, 74, 76 is temporarily unavailable and power from external sources such as the local grid infrastructure 80 is required to prevent shutdown of subsystems of the industrial gas production facility 10.

### CONTROL SYSTEMS

The industrial gas production facility 10 and power microgrid 12 of Figure 1 each have respective control systems 100, 200 which will now be described.

### POWER MICROGRID CONTROL 100

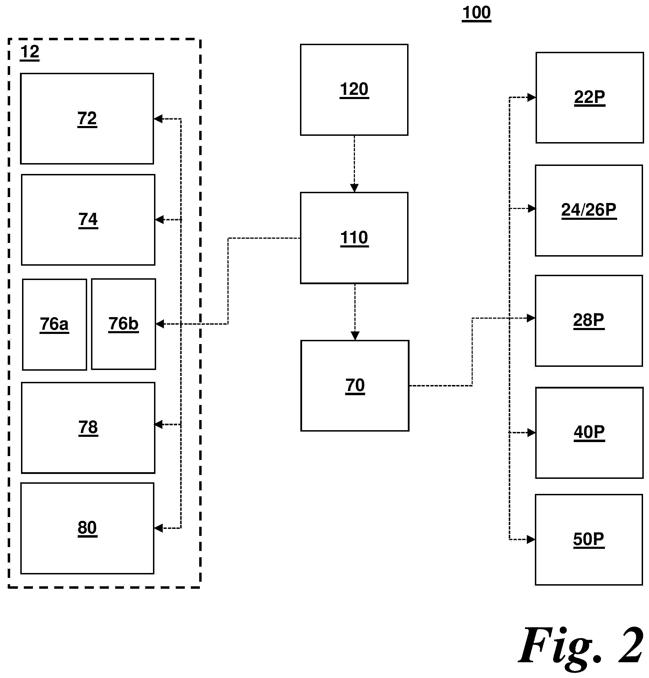

A schematic diagram of the components of the power microgrid control system 100 is shown in Figure 2.

The power microgrid control system 100 comprises a power management controller 110 and a weather management system 120. These control systems are operable to monitor and control the power generation and management systems of the power microgrid 12.

The power management controller 110 is connected to, and operable to send information to and from, the main microgrid bus 70 to control and monitor the respective power distribution centers (PDCs) for each of the production facility systems. As shown, PDCs 22P, 24P, 26P, 28P, 40P and 50P are provided for the electrolysers 22, LP compressor(s) 24, MP compressor(s) 26P, purification stages 28P, ASU 40 and ammonia production plant 50. The PDCs draw power from the main microgrid bus 70 in use.

### WEATHER MANAGEMENT SYSTEM 120

In embodiments, the weather management system 120 may be configured to receive environmental and meteorological measurements from, in embodiments, a weather and forecast database (not shown) which may comprise a weather data service or other internet-connected resource. Load, solar power and wind power data measured locally may also be used.

Based on the weather data received, the weather management system 120 may be configured to generate a model to predict future power generation. In embodiments, the weather management system 120 may comprise a machine learning algorithm implemented on a computing system to predict future power generation from a variable and/or intermittent source such as a renewable power source. This data is fed to the power management controller 110 and to the facility control system 200 as described below.

The function of the weather management system 120 is to estimate long term weather data. By long term weather data is meant timescales in excess of multiple hours. For example, the weather management system 120 may generate predicted power profiles (or power profile forecasts) for time periods of 24 hours, 48 hours or longer. In embodiments, the weather management system 120 may generate predicted power profiles for a multiplicity of days, and potentially weeks or months.

In embodiments, the weather management system 120 is operable to generate an updated prediction (or forecast) at predetermined intervals. For example, in embodiments, the weather management system 120 may generate an updated forecast every 10, 15 or 20 minutes. The updated power profile forecast is generated on the basis of a future time horizon, so each generated estimated power profile is for a predetermined time period (e.g. 24 hours) from the point of generation. This data is sent to the power management controller 110.

### POWER MANAGEMENT CONTROLLER 110

The power management controller 110 in the described embodiments monitors and manages available power in real time and also in view of the future predicted available power from the weather management system 120. The power management controller 110 may comprise a computing system having at least one hardware processor and is configured to control operation of the power elements of the power microgrid 12.

Given the inherent variability of renewable energy sources, the power management controller 110 may monitor parameters such as energy generation from the renewable power sources 72, 74, energy storage from the energy storage resources 76a, 76b and loads to/from the local power grid infrastructure 80, and controls aspects thereof.

For power generation infrastructure, the variables which may be monitored may include: Wind power *WP;* solar power SP; power load L; total available main microgrid bus power *TP;* and maximum power draw MPD.

In the present embodiments, these measurements and data feeds may be continuous and so may be measured in real time. However, in other arrangements the measurements may be performed at predetermined intervals.

Based on these variables, the power management controller 110 may control aspects of the power infrastructure. This may be done by means of a suitable control signal or data transmission to the relevant controllers of the power infrastructure components. The control signal may be configured to control power infrastructure to adjust the power generated by those components or (in the case of the energy storage 76a, 76b to control the flow of electrical power to or from the energy storage resource 76a, 76b)

In the case of the renewable power sources 72, 74, a control signal may be sent to the renewable power sources 72, 74 to enable control of the degree of power generation as a function of time. The control signal may be used to adjust the generated power. Note with any component there may a time delay during which the infrastructure component will ramp up or ramp down to adjust the generated power to the new value specified by the control signal.

In embodiments, the control signal sent to the renewable power sources 72, 74 may specify a desired power output either instantaneously as a fixed value or may specify desired power generation as a function of time. However, the specific mechanisms of control of the renewable power sources 72, 74 may be handled by local controllers of the renewable power sources 72, 74 and the power management controller 110 may be agnostic as to the specific control which takes place.

For the avoidance of doubt, control of specific elements of the renewable power sources 72, 74 is outside the scope of this disclosure. Nevertheless, one skilled in the art will be familiar with suitable techniques.

The power management controller 110 may monitor the maximum power draw from the main microgrid bus 70 which will set an upper constraint on the power which can be drawn at any one time.

The power management controller 110 is further operable to send usage, power and process data to external systems as required, as described below.

The power management controller 110 is operable, based on the control data and monitored data, to control the main microgrid bus 70 and PDCs 22P, 24P, 26P, 28P, 40P and 50P for the electrolysers 22, LP compressor(s) 24, MP compressor(s) 26P, purification stages 28P, ASU 40 and ammonia production plant 50.

The power management controller 110 also may comprise further functionality in terms of maintaining a feedback loop with regard to the predicted available power from the weather management system 120 when compared with the actual power generated within a predicted time window.

The power management controller 110 may compare the predicted available power in a predetermined time window (e.g. 24 hours) with the power actually generated during that time window once the time window has elapsed. Any difference between the predicted and actual power generation may be used to refine the prediction model. Variations may indicate equipment degradation or inefficiency, or expose particular inaccuracies in the prediction data used.

In addition, the power management controller 110 may adjust the control set point values for the power generation and/or storage in view of actual power generated in the predetermined window. For example, if less electrical power is stored in the predetermined window than required, the power management controller 110 may demand increased power generation beyond that required for running the industrial gas production facility 10 to ensure that the energy storage resources 76a, 76b are at the required capacity prior to a particular time period (e.g. before nightfall).

### ENERGY STORAGE CONTROL

For the energy storage infrastructure, the power management controller 110 may further receive information on the current state of the energy storage 76a, 76b, for example, battery level, available power, storage capacity. This may be captured by a general value of energy storage ES.

The power management controller 110 is also operable to control the energy storage 76a, 76b to store energy from the grid 80 when needed, and to provide additional power to the grid when needed. This may be on short term (rapidly varying) and long term (slowly varying) timescales.

The power management controller 110 is operable to control the energy storage 76a, 76b to handle power distribution and load on different timescales. In other words, the power management controller 110 is operable to control the energy storage 76a, 76b as both a power source and a power sink. For example, two scenarios that the energy storage 76a, 76b and power management controller 110 can handle are smoothing and disturbances.

Smoothing relates to scenarios in which an imbalance exists between the available renewable power from power sources 72, 74 and power demand from the industrial gas production facility 10. Such a situation may arise, for example, during the night when renewable power generation is low and the energy storage resources 76a, 76b may provide power to smooth the shortfall in power availability. Such smoothing operates on a time frame of minutes to hours.

Concomitantly, should the power demand from the industrial gas production facility 10 be lower than the available power generated by renewable sources 72, 74 (for example, during particularly strong sunshine or high winds when the industrial gas production facility 10 is running at a lower production rate or is ramping up) then the energy storage resource 76a, 76b can be utilized to take up the difference in power load and be charged with the excess power for later use.

In contrast, disturbances relate to short term (of the order of sub-second to several second duration) fluctuations and/or variations between power supply and power demand. Disturbances may relate to sudden changes in status of the power supply or power demand resulting from equipment failures or equipment coming online.

For example, in the case of the industrial gas production facility 10 described above, the failure of an electrolyser 22 would result in a sudden loss of power demand and a spike in excess available power. The energy storage resource 76a, 76b can thus function as a sink for this available power and act as a buffer to ensure the integrity of the power microgrid 12.

In addition, in embodiments, the power management controller 110 may control the energy storage resource 76a, 76b to maintain or achieve particular conditions within the energy storage resource 76a, 76b at particular time points. For example, the power management controller 110 may aim to ensure that the energy storage resource 76a, 76b has a particular fill or storage level of charge prior to nightfall.

### FACILITY CONTROL SYSTEM 200

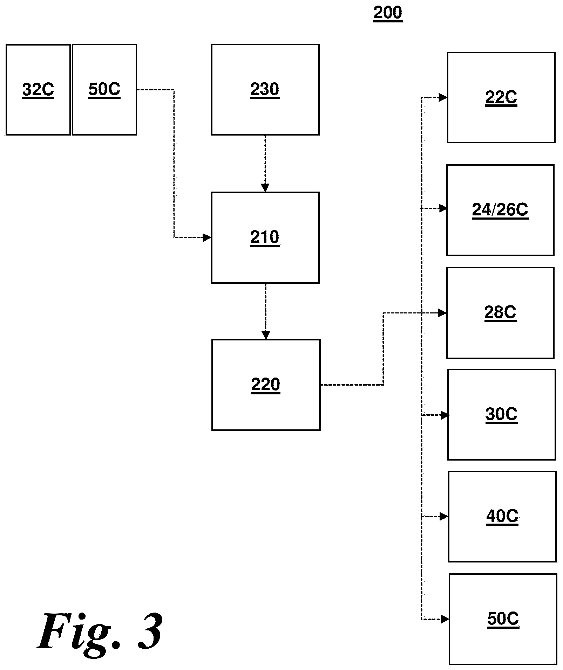

Figure 3 shows the facility control system 200. The facility control system 200 comprises a master facility controller 210, an automation system 220 which may comprise a Basic Process Control System and Safety Instrumented System (BPCS/SIS) and a power profile module 230.

Further, the facility control system 200 comprises capacity monitors 32C, 50C for the hydrogen storage 32 and ammonia storage 50 respectively, and load controllers 22C, 24C, 26C, 28C, 40C and 50C for the electrolysers 22, LP compressor(s) 24, MP compressor(s) 26P, purification stages 28P, ASU 40 and ammonia production plant 50 respectively.

### MASTER FACILITY CONTROLLER 210

The master facility controller 210 may, in embodiments, be operable to measure and control the necessary systems and output process data from each element of the industrial gas production facility 10.

This data is provided to the automation system 220 which is operable to control the industrial gas production facility 10 dynamically in response to this control data.

In embodiments, the master facility controller 210 receives information from the power profile module 230. The power profile module 230 is operable to provide power profile information relating to the predicted available power for a predetermined time period. The power profile module 230 may obtain available power data from the power management controller 110 and/or the weather management system 120. The master facility controller 210 can then generate control set points for controlling the respective load controllers based on the predicted available power over the predicted time horizon.

The master facility controller 210 may take any suitable form. For example, the master facility controller 210 may comprise model predictive control (MPC) which, in embodiments, comprises a multivariable control algorithm that utilizes an internal dynamic model of the process plant components, an appropriate cost function, and an optimization algorithm which is operable, in embodiments, to minimize the cost function using a plurality of control inputs.

Alternative functions may be used. These may involve, for example, similarity functions which are maximized.

In embodiments, the master facility controller 210 may implement model predictive control (MPC) to control the industrial gas production facility 10 in response to process variables and parameters whilst satisfying a plurality of constraints. The master facility controller 210 is arranged to receive inputs from the power profile module 230 and various facility control systems (described below) and derive a facility operation policy including set point operation parameters over a predetermined future time horizon. These are then fed to the production facility control systems to control the relevant processes controlled thereby.

In other words, the master facility controller 210 utilises a model predictive controller (MPC) implementing a dynamic model of the operation of the process industrial gas production facility 10. In embodiments, it may utilize linear empirical models obtained by system identification of the various processes. Alternatively or additionally, it may utilize non-linear high-fidelity models or non-linear models created from machine learning algorithms.

In embodiments, the master facility controller 210 utilizing MPC is operable to optimize the set points and processes for a present time period, whilst also being able to adapt for future time periods. This is achieved, in embodiments, by optimizing a finite time horizon for each of the processes whilst implementing the current time period. The optimization is then performed again at the next time period or window.

The master facility controller 210 is operable to communicate with the power management controller 110 to transmit control and power data to enable efficient running of the industrial gas production facility 10 and power microgrid 12. In embodiments, this may take the form of a continuous data transmission or at predetermined intervals. In embodiments, the master facility controller 210 is operable to send power demand data to the power management controller 110 at intervals of 60 to 90 seconds. However, other data transmission intervals may be used, for example, 30 seconds or 2 to 5 minutes.

The data received from the power management controller 110 comprises the predicted power profile data for a predetermined period (e.g. 24 hours). The predicted power profile data is updated at predetermined intervals, for example, every 15 minutes.

The updated predicted power profile data is received and processed by the power profile module 230 and then utilized by the master facility controller 210 to produce updated control set points for the various systems and subsystems of the industrial gas production industrial gas production facility 10.

In certain situations, the update may merely act as a perturbation on the predicted control regime implemented in response to the previous predicted power profile update. For example, consider a scenario where predicted operation based on the previous predicted power profile has been implemented over the finite time horizon. However, a short-term event which has a material impact on the generated power may be identified by the power management controller 110.

Such a short-term event may comprise, for example, reduced solar power generation due to local cloud cover or events such as a fire or volcanic eruption which generate smoke and/or debris. In this scenario, the real-time available power will be lower than expected this is reflected in the next predicted power profile update which sets the predicted power over a predetermined time period such as 24 hours. Then, a control signal from the power management controller 110 may be sent to the power profile module 230 and to the master facility controller 210 which can modify the control setpoints in view of the perturbation.

The automation system 220 is operable to utilize the generated control data and implement this control data to control the various production facility systems and subsystems. The automation system 220 may, in embodiments, be connected to a plurality of control elements in the form of load controllers 22C, 24C, 26C, 28C, 40C and 50C for the electrolysers 22, LP compressor(s) 24, MP compressor(s) 26P, purification stages 28P, ASU 40 and ammonia production plant 50 respectively.

The control data and control set points are subject to constraints. For example, maximum and minimum operating points define the operating range of a process plant, and there is often significant interdependency between plant components.

Each production process within the industrial gas production facility 10 has a maximum and minimum operational capacity. In addition, in a dynamic operation a maximum rate of change of production capacity. These constraints are typically set by mechanical constraints or other physical constraints within the equipment.

The set point rates are influenced by power constraints which may apply for each process plant in the industrial gas production facility 10, and collectively for the total power draw to run the industrial gas production facility 10 in a given condition. Power constraints may be determined through one or both of the power profile data and power information received from the power management controller 110.

In addition, the set point rates are governed by process constraints. Process place constraints on the maximum and minimum capacity for each plant, together with constraints on the rate of change of production capacity (i.e., ramp rates) in response to controller set point changes etc. Physical equipment limitations, quality and/or safety parameters may also apply.

These elements may comprise any suitable controller, for example, proportional-integral-derivative (PID) controllers. Details of these elements are described below.

### HYDROGEN PRODUCTION PLANT CONTROL

Various control elements are provided for the hydrogen production plant 20. The electrolyser load controller 22C may be configured to monitor parameters of the electrolysers. For example, the controller 22C may monitor the power demands, output, amount and rate of generation of hydrogen gas from the electrolysis by direct or indirect measurement utilising appropriate variables or sensors.

A measurement of output and rate of hydrogen generation may be derived from sensor measurements such as direct flow measurements, or alternatively inferred through indirect measurements such as the electrolyser current or power demand.

Operational characteristic variables which may be measured and/or controlled may comprise: electrolyser power consumed EP; electrolyser hydrogen produced EH; demin water flow ED; average cell temperature ECT; average cell pressure ECP; and current flowing through the electrodes I.

The compressors 24, 26 each have a load controller 24C,26C. Controllers 24C, 26C are operable to control and measure parameters associated with each of the LP and MP compression stages 24, 26. For example, such parameters may comprise power utilisation (i.e. power consumed CP), compression volume, compressor pressure HCP, flow HCF, run time, ramp rate etc. The efficiency of the compressor system may also be tracked using the compressor power consumed, CP.

The purification stage 28 also has a load controller 28C. This may control and monitor operation of purification elements such as De-Oxo and Temperature Swing Adsorption (TSA) devices. Parameters measured or monitored for these devices may include gas forward flow and power consumption.

The DeOxo and TSA may comprise a plurality of trains and the system may be designed to operate up to 50% of the maximum load for each train. One train may be under flow control using a flow indicating controller (FIC) whilst the or each remaining train may be under pressure control using a pressure indicating controller (PIC).

The master facility controller 210 may function with one train in FIC control and one in PIC control. In use, the PIC controller set point will be unchanged and the FIC set point will be modulated by the master facility controller 210 to balance the flow over each train. Within the train itself the control will actively adjust to changing loads through the controllers. In summary, the master facility controller 210 is operable to adjust the flow control to the train using the FIC controller and the PID controllers will respond automatically to the flow changes.

### HYDROGEN STORAGE CONTROL

For the hydrogen storage load controller 32C, the pressure and flow of compressed hydrogen from electrolyser and compression system to the storage system may be monitored, as well as the storage pressure, and pressure and flow of compressed hydrogen gas to the ammonia plant 50 may be monitored and controlled. This data may include maximum storage pressure and/or storage pressure ramp variables; for example, maximum and minimum constraints on rate of change, i.e., how quickly flow and/or pressure can be increased and how quickly it can be reduced.

Real-time tracking of the hydrogen storage unit 30 may be based on measurement and control of variables such as: storage system pressure and temperature, SP, ST; hydrogen compressor pressure and flow, HCP, HCF. The load controller 32C may comprise one or more PID controllers operable to maintain particular set point values within the system as required.

### ASU CONTROL

The ASU 40 has a load controller 40C which is operable to measure and control parameters associated with the performance of the ASU 40 including power requirements, operating capacity, Nitrogen output volume and rate, and ramp up/ramp down rates for operation.

If nitrogen storage is provided then nitrogen storage control (not shown) may also comprise measurement and prediction data relating to the Nitrogen storage 42 including, but not limited to: storage volumes, compression, capacity, discharge rates, specific power, nitrogen recovery, and temperature differences in a heat exchanger forming part of the ASU.

### AMMONIA LOOP CONTROL

The ammonia load controller 50C may, in embodiments, be operable to control a single unit equilibrium reactive system which processes the synthesis gases of nitrogen and hydrogen to produce ammonia. Nitrogen is provided by the ASU 40 which, in embodiments, is running continuously to provide nitrogen, or the LIN SVD 42 as required.

Hydrogen is provided from the hydrogen production plant 20 if it is running based on the availability of the renewable power at given instance or else hydrogen is fed from the hydrogen storage 30. Stoichiometric composition of synthesis gas is processed by a syn-gas compressor forming part of the ammonia plant system and the product is refrigerated by another set of compressors and sent to storage.

The performance of the ammonia loop is governed by the equilibrium conversion of the exothermic reaction and is monitored in real-time based on the predictive model for feed to the ammonia loop, AF as a function various predictor variables, including: power consumed by ammonia loop, AP, ammonia loop pressure and temperature, ALP, ALT; feed flow rates of nitrogen and hydrogen streams, ANF, AHF; and ammonia plant syngas compressor pressure, ACP.

### MASTER FACILITY CONTROLLER 210 OPERATION

In use, the master facility controller 210 utilizes predicted power profile data from the power profile module 230 and predicted characteristic data from the computational model(s) in an optimization model to generate a set of manipulated variables for the plurality of industrial gas plants and the industrial gas storage.

At time sample t, the predicted values of the manipulated variables for a prediction time horizon P are determined based on the measured values of the plant variables at time t. Within the prediction time horizon, a set of discrete manipulated variable set points are calculated between time t and time t+P.

The discrete set of variables are set at a predetermined interval. For example, M set point variables may be determined between time t and time t+P, where M is any suitable integer. The set points may be evenly spaced in time.

In embodiments, this may be done by solving an optimization problem forming the computational model. The optimization problem is solved factoring in both power resource availability and constraints and process plant capacity and both static (e.g., capacity) and dynamic (e.g., ramp rate) constraints.

These manipulated variable values are utilized to generate a set of control set points for the plurality of industrial gas plants and the gas storage, which are then sent to the automation system 220 to control the industrial gas production facility 10 by adjusting one or more control set points of the industrial gas plants.

### POWER MICROGRID AND INDUSTRIAL GAS PRODUCTION FACILITY DATA EXCHANGE

The power microgrid control 100 is operable to monitor and control elements of the power microgrid 12, and the facility control system 200 is operable to monitor and control the industrial gas production facility 10 subsystems in response to present and predicted power availability.

However, the inventors of the present invention have recognized that communication between the power microgrid 12 and industrial gas production facility 10 can improve the synergy, reliability and efficiency of these systems. The inventors of the present application have recognised, for the first time, that the sending of power demand control signals from the industrial gas production facility 10 to the power microgrid 12 can improve the efficiency, reliability and general operation of the power microgrid 12.

The power demand control signals indicate the real-time and predicted power demands of the industrial gas production facility 10 over a future time horizon or for a predetermined time period. This differs from known arrangements where power for an industrial gas production facility may be received from a main grid or other grid source. In general, such an industrial gas production facility will simply utilize the power it requires in the form of a passive consumer. In general, the main grid will be able to supply sufficient power for the industrial gas production facility to be run under normal operation, and the main grid will then respond automatically to the required power demands. This is, in part, due to the fact that the industrial gas production facility is, in general, one of many consumers of power within the grid network.

Renewable power presents a different challenge. The intrinsic variability of renewable power can have a material impact on the operation of an industrial gas production facility as discussed above. However, power balance is also an important issue in smaller networks and microgrids.

For example, power supply cannot always be matched to changes in demand, particularly for rapid changes in demand, and handling of excess power is often problematic unless a grid connection is available to take the excess load. In many cases, for example in situations where the microgrid and industrial gas production facility are located in remote or isolated facilities, excess power can present significant challenges because of the lack of a suitable sink for that power.

Whilst the facility control system 200 is operable to control the industrial gas production facility 10 based on available or predicted available power to handle power-limited scenarios, there will be situations where available power exceeds current demand. This excess available power needs to be handled efficiently to avoid upsets in the power microgrid 12.

In addition, in certain scenarios (for example, equipment failure) there will be a sudden change in power demand. This can cause additional issues in the power microgrid 12 where a sudden drop in demand leads to excess power to be dissipated.

In both of the above scenarios, process knowledge of current and/or future conditions in the industrial gas production facility 10 can improve the operation and reliability of the power microgrid 12 because either suitable corrections or action can be taken.

This potential synergy between power supply and demand load is unique to the present invention which, through the monitoring, control and prediction of the subsystems of the industrial gas production facility 10 has detailed information on the status of power-utilizing components.

### COMMUNICATION NETWORK

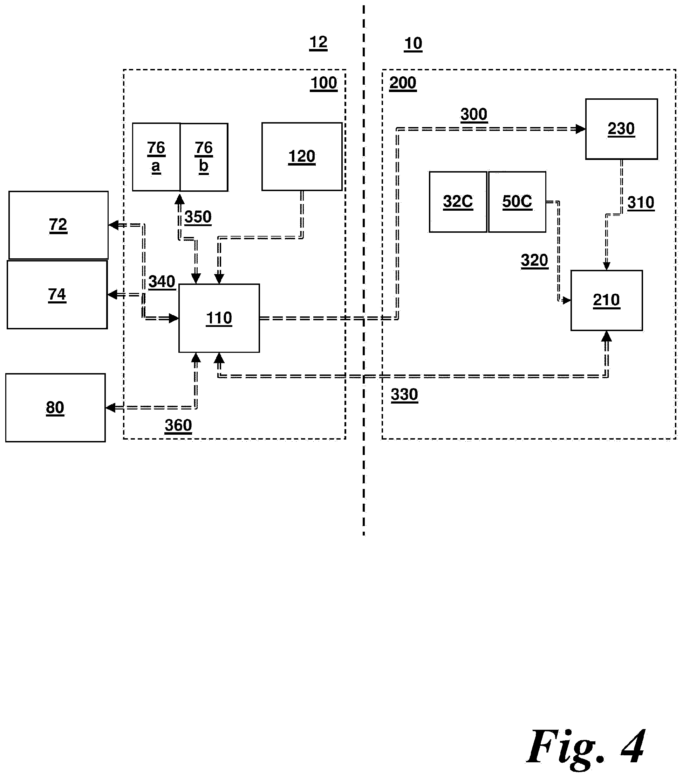

Figure 4 shows a generalised schematic network of the components of the power controller 100 shown in Figure 2 and the facility control system 200 shown in Figure 3 which are operable to communicate via control signals. It should be understood that this diagram is schematic and additional components or fewer components may engage in signal feedback and communication as appropriate.

Figure 4 shows the flow of data signals between the relevant components of the power microgrid 12 and the industrial gas production facility 10.

Data signal 300 is received by the power profile module 230 from power management controller 110. The power profile module 230 provides the power profile data to the master facility controller 210 via data signal 310. This data enables a suitable power profile to be derived in order to develop a production facility control strategy for current and future demand.

In addition, sensor and other data 320 in relation to the gas storage resources (in this embodiment, hydrogen storage 32C and ammonia storage 50C) is provided to the master facility controller 210 to provide at least data in relation to storage capacity and fill levels.

A data connection 330 is provided between the power management controller 110 and the master facility controller 210. In embodiments, the data connection 330 is bidirectional and control signals can be sent from the power management controller 110 to the master facility controller 210, and from the master facility controller 210 to the power management controller 110.

Whilst for the purposes of this embodiment a single data connection 330 is shown and described for the purposes of clarity, it is to be understood that this may take any suitable form. For example, separate channels or separate data links may be provided for back-and-forth communication. Further, the data connection 330 may in embodiments be one way only and may be from the master facility controller 210 to the power management controller 110 only.

The data connection 330 will be discussed in detail below and comprises data relating to the current power demand status of the industrial gas production facility 10, future power demand status, constraints on power demand, plant status and equipment status. The data connection 330 enables the power management controller 110 to control elements of the power microgrid 12 and/or take action as appropriate.

In embodiments, the data connection 330 is two way and communications data may be sent from the power management controller 110 to the master facility controller 210. This information may include, for example, data relating to the current capacity, availability and/or charge level of the energy storage resources 76a, 76b.

The power management controller 110 is further operable to send and receive control signals 340, 350, 360 to the renewable power sources 72, 74, energy storage 76a, 76b and grid connection 80.

More particularly, as described above, the power management controller 110 is operable to control the flow of power to or from the energy storage 76a, 76b to smooth power supply and demand, and to handle disturbances in the network.

### POWER PROFILE CONTROL SIGNAL - MICROGRID TO PRODUCTION FACILITY

Data signal 300 is received by the power profile module 230 from power management controller 110. The data signal 300 comprises predicted power profile data which is sent at predetermined intervals.

For example, updated power profile data is generated on the basis of a future time horizon so each generated estimated power profile is for a predetermined time period (e.g. 24 hours) from the point of generation. This data may be sent via data signal 300 at predetermined intervals. In embodiments, this data may be sent every 15 minutes.

The data that is sent via data signal 300 comprises predicted power profile data indicating the predicted available power for the predetermined period (e.g. 24 hours). As described above, this data is generated based on the environmental predicted data received by weather management system 120 and may be modified by the power management controller 110. The data may be modified in view of a comparison made between the predicted power generation and the actual power generated for the same period. In other words, the data sent to the power profile module 230 may also include modifications made on the basis of real-time actual data.

The power profile module 230 provides the power profile data to the master facility controller 210 via data signal 310. This data enables a suitable power profile to be derived in order to develop a production facility control strategy for current and future demand.

In optional embodiments, the data connection 330 may further be operable to send power data from the power management controller 110 to the master facility controller 210. This may be utilized in scenarios where power limitations or other data is necessary for efficient operation of the industrial gas production facility 10.

For example, the power management controller 110 may monitor the maximum power draw from the main microgrid bus 70 which will set a constraint on the power which can be drawn at any one time and this information may be transmitted to the master facility controller 210.

This value may change in use in response to ambient conditions or short-term perturbations. This power control information can be sent by the power management controller 110 to exchange control and power data to enable efficient running of the industrial gas production facility 10 and power microgrid 12.

### POWER MANAGEMENT CONTROL SIGNALS - PRODUCTION FACILITY TO MICROGRID

The inventors of the present application have recognised that the ability to send control data from the industrial gas production facility 10 to the power microgrid 12 can improve operation of the power microgrid.

In embodiment, the master facility controller 210 is operable to send data via data connection 330 to the power management controller 110. In embodiments, the data sent via data connection 330 comprises data including the power demand of the industrial gas production facility 10. This enables the power management controller, 110 to control the power resources in response to the power demand from the industrial gas production facility 10.

In embodiments, the power demand data sent to the power management controller 110 via data connection 330 may also comprise real-time information on the status of the industrial gas production facility 10. For example, sudden equipment failure or equipment servicing, or new or replacement equipment coming online.

This information may, in embodiments, be reflected in the power demand signal. For example, an equipment failure will result in a sudden change in power demand which may be reflected in a change in the power demand data sent to power management controller 110.

Alternatively or additionally, specific equipment data may also be sent on the same data channel or a separate channel.

Alternatively or additionally, the data connection 330 may comprise data on future power demands or equipment needs. For example, if scheduled maintenance of equipment is known in advance which will result in lower power demands, this information could be sent to the power management controller 110 and may form part of the power demand data.

The data connection 330 may be in real-time and provide continuous data on the industrial gas production facility 10 or may be at predetermined intervals. In embodiments, the power demand data may be sent at 60 - 90 second intervals.

In embodiments, the power demand data may comprise predicted power demand for the industrial gas production facility 10 for the time horizon P and may comprise a set of discrete power demand values between present time t and time t+P.

### POWER DEMAND DATA

As outlined above, the master facility controller 210 has information on estimated available power from the power profile module 230 and information on plant systems and operation. This information enables calculation of a maximum theoretical production rate for the industrial gas production facility 10 for a particular time t.

Then, with knowledge of the process rates at which the various components of the industrial gas production facility 10 must be run at in order to achieve the maximum theoretical production rate, a value of power demand for operation in this regime can be determined. This may be determined for the time horizon P, and at predicted discrete intervals from time t to *t+P.*

Taking the example of an ammonia production industrial gas production facility 10, in situations where sufficient renewable power is available and is predicted to be available for a suitable future time window, the industrial gas production facility 10 can be run at the maximum theoretical production rate for ammonia production. This is based on full availability of all operational subsystems and that suitable capacity is available in the gas storage resources 32, 50.

Therefore, the maximum production rate defines an upper limit on the plant production and on the power demands of the production facility. Even if available power exceeds the required power, the production rate will not be increased due to production facility operating constraints.

Thus, the master facility controller 210 is operable to derive quantitative power demand data from process plant data. This data can be sent to the power management controller 110 in the form of a power demand control signal. This may include the current and predicted power demand in any suitable form.

Various scenarios affect the ability of the industrial gas production facility 10 to operate at the maximum theoretical production rate. In the case of an ammonia plant, when operating at the maximum level, hydrogen production is at a maximum. Under these conditions, in specific non-limiting embodiments, 75% of the produced hydrogen is used by the ammonia plant 50 and 25% of the hydrogen is passed to the hydrogen storage resource 32.

However, if the hydrogen storage is, or is approaching, a maximum level, then the production rate of the industrial gas production facility 10 must be ramped down so that the amount of hydrogen produced is equal to or less than that required by downstream processes such as the ammonia plant 50, and no further hydrogen is pushed to the storage resource 32. If excess hydrogen cannot be stored, it must be vented or flared, which is commercially undesirable. Further, if major equipment is not available then the production rate must be ramped down accordingly. For example, consider the unavailability of an LP Compressor 24 due to servicing or equipment failure. In this case, the electrolyser 22 will have a maximum output which is reduced below the maximum operation rate to ensure that the system remains stable and the remaining operational compression elements can handle the produced hydrogen. Thus, in embodiments, the electrolyser 22 may be limited to 80% of full capacity, which corresponds to one out of five LP compressors being temporarily unavailable.

Thus, under the above scenario, the power demand variable will have a value which is correspondingly lower to reflect the reduction in operational equipment.

This is one non-limiting example are repeated for all operational equipment. Thus, the master facility controller 210 and automation controller 220 can determine, for any configuration of operational/non-operational subsystems, a calculated maximum theoretical demand is calculated.

This data can then be sent by the data connection 330 to enable the power management controller 110 to control the power microgrid 12 in response thereto to mitigate the risk of additional unused power which cannot be utilized by the industrial gas production facility 10 or which cannot be stored being generated.

### PLANT FAILURE SCENARIOS

The following examples set out potential equipment failures and losses which will impact on the production rate of the industrial gas production facility 10 and correspondingly on the power microgrid 12.

### FULL INDUSTRIAL GAS PRODUCTION FACILITY FAILURE

Such a situation may arise if there is a power trip of one or more incomers or transformers of the power microgrid 70. If the industrial gas production facility 10 is operating at a maximum capacity (i.e. full load) this may result in further power trips through loss of cooling to the production and process units. A longer duration trip may result in electrolysers 22 and hydrogen compressors shutting down due to excessively high temperatures.

This will result in an instantaneously reduced load on the power microgrid 12 which may be of the order of GWs.

### HYDROGEN PRODUCTION FAILURE SCENARIOS AND MITIGATION

The following examples detail equipment failures which may occur within the hydrogen production plant 20 and the corresponding effects on the industrial gas production facility 10 and power microgrid 12.

If an incomer or transformer to the electrolysers 22a ... 22n trips this will result in a shutdown of a plurality of electrolysers 22. This will then reduce pressure in the header of the LP compression stage 24, and the LP compression stage 24 will reduce forward flow to maintain suction pressure. Whilst this may ultimately not impact production of hydrogen, it will cause an instantaneous reduction in power load equal to the power demands of the electrolysers 22 which have tripped. This may be of the order of MWs.

If an LP compressor 24 is tripped, a controlled load reduction from the electrolysers 22 may be initiated. This may be done through the master facility controller 210. As described below, communication between the master facility controller 210 and the power management controller 110 may initiate before any load reduction to enable adjustment of available power in response to the reduced demand. The power reduction may of the order of tens of MWs.

If a MP compressor 26 is tripped, forward flow would be reduced. The severity would depend upon whether gas was being received from the hydrogen storage 32 or solely from the electrolysers 22.

If a MP compressor 26 is tripped, a controlled load reduction from the electrolysers 22 may be initiated. This may be done through the master facility controller 210. As described below, communication between the master facility controller 210 and the power management controller 110 may initiate before any load reduction to enable adjustment of available power in response to the reduced demand. The power reduction may of the order of tens of MWs.

A failure in the purification stage 28 would result in an immediate reduction in forward flow of hydrogen. The LP and MP Compression stages 24, 26 may move to a recycle mode and the load on the electrolysers 22 may be reduced in a controlled manner.

This may be done through the master facility controller 210. As described below, communication between the master facility controller 210 and the power management controller 110 may initiate before any load reduction to enable adjustment of available power in response to the reduced demand. The power reduction may of the order of hundreds of MWs.

### ASU PLANT FAILURE SCENARIOS

The loss of the ASU 40 may result in a drop in pressure followed by a return to normal values as a backup Liquid nitrogen vaporisation process is started. However, power demand will fall by the order of tens of MWs in the short term.

### AMMONIA PLANT FAILURE SCENARIOS

If the ammonia plant is tripped, there will then be no forward flow from the ammonia plant 50. In embodiments, a controlled load reduction may take place to reduce the hydrogen production by reducing the load on the electrolysers 22a ... 22n.

This may be done through the master facility controller 210. As described below, communication between the master facility controller 210 and the power management controller 110 may initiate before any load reduction to enable adjustment of available power in response to the reduced demand. The power reduction may of the order of hundreds of MWs.

### INSTRUMENT AIR LOSS

Many valves and control systems are controlled by pressurised air systems. Such a loss would in general comprise a temporary event because emergency power is used to restart the appropriate compressors. Multiple further trips may result from lack of control of processes.

### FAILURE MODE SUMMARY

As described above, numerous failure modes have an impact on the power microgrid due to sudden changes in power demand. However, in a significant number of scenarios, the present invention is operable to mitigate the impact of these failures on the integrity of the power microgrid 12 as noted above and described below.

### NORMAL OPERATION OF POWER MICROGRID-PLANT COMMUNICATION CONTROL

In operation, the power microgrid 12 systems and industrial gas production facility 10 systems are operable to communicate in order to improve the reliability and efficiency of the power microgrid 12.

The primary communication channel or channels is via data connection 330 between the power management controller 110 of the power control system 100 and the master facility controller 210 of the facility control system 200. A data feed including the power demand data on data connection 330 may be sent at predetermined intervals from the master facility controller 210 to the power management controller 110 (e.g. 60 to 90 seconds). However, in other embodiments this data may be on demand or continuous.

The power management controller 110 is operable to provide the power profile module 230 with power profile data relating to the predicted maximum available supply power for the predetermined time period (e.g. 24 Hours). This may be received at predetermined intervals (e.g. every 15 mins).

The master facility controller 210 utilizes this power profile information in order to control the plant systems and generate predicted control set points for the plant systems for the finite time horizon P. The master facility controller 210 may then transmit power demand data representative of the current and/or short-term future power demand of the industrial gas production facility 10 via the data connection 330. This may be for the predicted time horizon P. In embodiments, the time horizon P is 24 hours.

The power demand data may intrinsically include information that an increased load on the power supply is expected (e.g. equipment coming online) or that equipment is coming offline for repair or maintenance since this may be embedded in the power demand data for the predicted time period. However, in embodiments, the control signal 330 may also include other metadata with regard to specific components and their status.

The data connection 330 enables various operational scenarios to be managed and optimized. In, for example, demand-limited scenarios where the industrial gas production facility 10 can be operated at full capacity, the updated power profile data sent via data connection 300 may not alter the predetermined control set points for the finite time horizon P determined by the MPC-based model of the master facility controller 210.

However, in this scenario, the power demand data from the master facility controller 210 sent via the data connection 330 may enable the power management controller 110 to manage the available power such that the available power does not exceed the real-time and short-term demand. In other words, the power management controller 110 will ensure that only the power required by the master facility controller 210 is provided to the industrial gas production facility 10.

This may be achieved in multiple ways. For example, the power management controller 110 may transmit a control signal to the renewable power sources 72, 74 via data channel 340 to enable curtailment of the power generation to be effected on a temporary or short-term basis. In embodiments, this may include control set points or a desired value of a variable representing the generated power. Control of the renewable power sources 72, 74 is handled outside the power management controller 110 although these operations may be informed by the control signals or variables from the power management controller 110.

Additionally or alternatively, with data regarding the required and estimated power demand, the power management controller 110 may control the energy storage resource 76a, 76b via data channel 350 in order to direct any additional power to the energy storage resource 76a, 76b. Depending upon the capacity of the energy storage resource 76a, 76b, this may reduce or eliminate the need for curtailment.

This may also be done in order to achieve a particular charge level for the energy storage resource 76a, 76b at a particular time point, e.g. to ensure close to a full charge prior to nightfall.

Additionally or alternatively, any excess power may be supplied to the external grid 80. In some scenarios, power may be sold to the external grid 80. However, this is a less preferred outcome and, in many situations (e.g., isolated or remote plant facilities and local microgrids) it simply may not be possible to use an external microgrid 80 as a power sink and alternative power management, through curtailment or storage, is necessary.

Other illustrative cases demonstrate the control synergy between the control systems 100, 200.

Consider, for example, a situation where a change in the real-time or short-term available power generation occurs (e.g. renewable equipment failure or change in ambient conditions different from that as previously predicted). This will lead to updated power profile data which reflects the changed predicted power generation for the predetermined period.

At the next interval, this updated power profile data is transmitted to the power profile module 230. This updated power supply information indicates that the current demand exceeds supply and that the industrial gas production facility 10 is required to ramp down the production rate to reduce power demand. As a result, new control set points for the time horizon P may be set by the MPC forming part of the master facility controller 210 given the available power is expected to be insufficient to maintain the industrial gas production facility 10 at the current production rate.

However, each process plant has a particular range of capacity ramp rates which must be adhered to. For example, ramp rates between two different operational capacity levels are determined at least in part by mechanical, chemical and physical limitations or requirements of the individual subsystems of the industrial gas production facility 10. This will determine the power demand profile.

For example, in embodiments, the ramp rates for the hydrogen production plant 20 (e.g., electrolysers and compressors) may be of the order of tens of % per minute. However, ramp rates for the ammonia production plant 50 may be of the order of tens of % per hour.

In addition, ramp rates may be limited by other constraints such as safety requirements. For example, the possibility of a vacuum occurring in an electrolyser system if too aggressive a ramp rate is applied is a considerable safety issue.

Finally, it is often undesirable to ramp down process systems at even the maximum practical rate and a reduced ramp rate is preferable.

In order to address this issue, the power management controller 110 therefore may provide power profile data including a ramping rate and timescale. This information may be included as control data.

If the ramping rate defined by the power supply information control data is lower than that permitted by the industrial gas production facility 10, then the lower rate can be adopted by the master facility controller 210 and the industrial gas production facility 10 brought to a reduced production rate (and consequently lower power demand) as gradually as possible.

However, in scenarios where the ramping rate required by the power management controller 110 is greater than the maximum available for the industrial gas production facility 10 (for example, in a situation of a sudden shortfall in power due to equipment damage or sudden environmental changes), then the offset between the desired power supply ramp rate and the industrial gas production facility maximum ramp rate will lead to a power supply and demand imbalance for the timescale during which the industrial gas production facility 10 transitions to a reduced production rate.

In these scenarios, the power management controller 110 is operable to control the energy storage resource 76a, 76b to supply the additional power needed to maintain the slower ramp rate required by the industrial gas production facility 10.

Following such a transition to a reduced production rate, should additional renewable power become available in excess of that currently required by the industrial gas production facility 10, then the opposite process occurs.

The power management controller 110 sends a ramp up control signal to the master facility controller 210 via data connection 330 to ramp up the industrial gas production facility 10 to handle the additional power which is now available.

A ramp rate and timescale may be specified in the power supply information control data sent via data connection 330. Again, if the ramp rate exceeds that permitted by the industrial gas production facility 10 then the offset in power availability vs demand as a function of time is handled by the energy storage 76a, 76b which, in this situation, is required to store power during the time period when available power exceeds the power demand whilst the industrial gas production facility 10 is ramped up to an increased production rate.

In summary, during normal operation the industrial gas production facility 10 is designed to ramp up and down in response to the available power and this can be achieved through the data connection 330 between the power control system 100 and the facility control system 200.

A further scenario is plant demand led. Consider a situation where the hydrogen storage 32 and/or ammonia storage 60 are close to or at full capacity. In such situations, the master facility controller 210 will set a new reduced production rate for the industrial gas production facility 10, with a suitable ramp down rate to achieve the new production rate.

In this scenario, the master facility controller 210 sends power demand data including a ramp down control signal to the power management controller 110 to indicate that the industrial gas production facility 10 is ramping down and demand may be reducing within the predicted demand time horizon.

This will enable the power management controller 110 to select an appropriate action to reduce the available power, either through curtailment, control of energy storage resources 76a, 76b to store additional power or (optionally) through transfer of power to the external grid 80. Again, the energy storage resource 76a, 76b is utilized as a buffer for handling the offset between available power and demanded power.

In these scenarios, the energy storage resource 76a, 76b is utilized as a suitable source or sink in order to contribute to the power smoothing element and take up the offset between the available power and the power demand. However, the power management controller 110 must also manage the energy storage resource 76a, 76b (via data connection 350) to ensure a balance of available power and available capacity.

As described below, the energy storage resource 76a, 76b has further functions in terms of management of power disturbances. In other words, the energy storage resource 76a, 76b must also stabilise the microgrid frequency and deal with any sudden disturbances to ensure that the integrity of the power microgrid 12 is protected.

### FAILURE SCENARIOS

In the scenarios described above, failures of plant equipment can lead to sudden disturbances and short-term imbalances in power availability and demand.

Sudden disturbances (of the order of sub-second to several second duration) and/or variations between power supply and power demand require immediate correction. In such scenarios, transmission of alert data from the master facility controller 210 to the power management controller 110 via the data connection 330 may have value in terms of short-term power management but may be too slow to address the disturbance in the power microgrid 12.

Therefore, in this scenario the power management controller 110 is operable to control the energy storage resource 76a, 76b automatically to act as a sink for this available power and act as a buffer to ensure the integrity of the power microgrid 12.

However, in the majority of failure scenarios, an alert control signal from the master facility controller 210 to the power management controller 110 can have significant benefits. As noted above in relation to failure scenarios, the failure of equipment such as LP or MP compressors will lead to a temporary and relatively small reduction in power demand.

However, to address the failure on the plant-side, a reconfiguration of the hydrogen production plant 20 may occur in which one or more electrolysers 22a ... 22n may be shut down to ensure compressor integrity. An alert control signal sent from the master facility controller 210 and the power management controller 110 on data connection 330 enables the power management controller 110 to take action to reduce power in anticipation of the load reduction.

Such advance warning enables the power microgrid 12 to be managed in a preferred manner with greater efficiency, integrity and reliability.

### METHOD

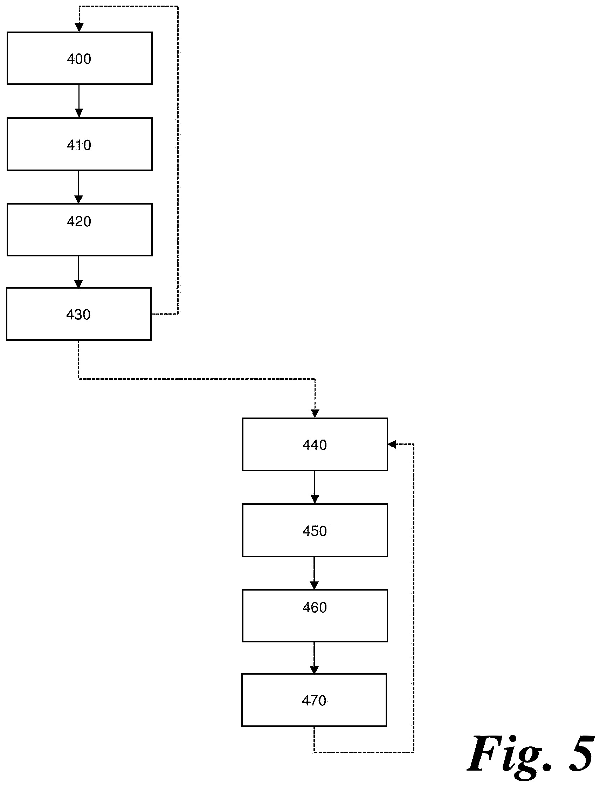

Figure 5 shows a method according to an embodiment. In embodiments, there is provided a method of managing power in a power microgrid configured to supply electrical power to an industrial gas production facility comprising a facility controller and one or more industrial gas plants. The power microgrid comprising a power controller, one or more renewable power sources and one or more energy storage resources. The method is executed by at least one hardware processor.

At step 400, the weather management system 120 may be configured to receive environmental and meteorological measurements from, in embodiments, a weather and forecast database (not shown) which may comprise a weather data service or other internet-connected resource. Load, solar power and wind power data measured locally may also be used.

Based on the weather data received, the weather management system 120 generates a model to predict future power generation. In embodiments, the weather management system 120 generates an updated prediction (or forecast) at predetermined intervals.

For example, in embodiments, the weather management system 120 may generate an updated forecast every 10, 15 or 20 minutes. The updated power profile forecast is generated on the basis of a future time horizon so each generated estimated power profile is for a predetermined time period (e.g. 24 hours) from the point of generation. This data is sent to the power management controller 110.

At step 410, the power management controller 110 monitors available power. Given the inherent variability of renewable energy sources, the power management controller 110 may monitor parameters such as energy generation from the renewable power sources 72, 74, energy storage from the energy storage resources 76a, 76b and loads to/from the local power grid infrastructure 80, and controls aspects thereof.

At step 420, the power management controller 110 may compare the predicted available power in previous predetermined time window (e.g. 24 hours) with the power actually generated during that time window once the time window has elapsed. Any difference between the predicted and actual power generation may be used to refine the prediction model. Variations may indicate equipment degradation or inefficiency, or expose particular inaccuracies in the prediction data used.

In addition, the power management controller 110 may adjust the control set point values for the power generation and/or storage in view of actual power generated in the predetermined window. For example, if less electrical power is stored in the predetermined window than required, the power management controller 110 may demand increased power generation beyond that required for running the industrial gas production facility 10 to ensure that the energy storage resources 76a, 76b are at the required capacity prior to a particular time period (e.g. before nightfall).

At step 430, an updated predicted power profile for the *n^{th}* predetermined time period is sent to the facility control system 200 via data connection 300. Steps 400 to 430 are then repeated for the next time interval (i.e. the *n*+*1^{th}* predetermined time period)

At step 440, the master facility controller 210 is operable to generate time-dependent predicted power demand data representative of at least a predicted power demand of the industrial gas production facility for a predetermined time period.

The data is generated based on the predicted power profile data sent in step 430 and received by the facility control system 200, the master facility controller 210 is operable to determine quantitative power demand data from process plant data relating to the process plants for a predetermined period.

The master facility controller 210 has information on estimated available power from the power profile module 230 and the updated power profile sent in step 420. The master facility controller 210 also has information on plant systems and operation. This information enables calculation of a maximum theoretical production rate for the industrial gas production facility 10 based on the available power for the predetermined time horizon.

Then, with knowledge of the process rates at which the various components of the industrial gas production facility 10 must be run at in order to achieve the maximum theoretical production rate, a value of power demand for operation in this regime can be determined.

At step 450, the master facility controller 210 is operable to generate and send a power demand signal via a data connection 330 to the power management controller 110. In embodiments, the data sent via data connection 330 comprises data including the power demand of the industrial gas production facility 10. This enables the power management controller, 110 to control the power resources in response to the power demand from the industrial gas production facility 10. This data is sent intermittently. In embodiments, this data is sent every 60 to 90 seconds.

Alternatively or additionally, specific equipment data may also be sent on the same data channel or a separate channel. Alternatively or additionally, the data connection 330 may comprise data on future power demands or equipment needs. For example, if scheduled maintenance of equipment is known in advance which will result in lower power demands, this information could be sent to the power management controller 110 and may form part of the power demand data.

At step 460, the power management controller 110 utilizes the predicted power demand data to generate control set point values for controlling a generated power output of the one or more renewable power sources and for controlling a flow of electrical power to or from the energy storage resources. The control set point values are selected to adjust the available power as a function of time for the predetermined time period to correspond to the demanded power for the predetermined time period.

At step 470, the power management controller 110 sends one or more control signals comprising the control set point values to the one or more renewable power sources and to the one or more energy storage resources. The power management controller 110 controls the power resources in response to the power demand control signal received from the master facility controller 210 via the data connection 330 in order to match the available power to the power demand.

The above process in steps 440 to 470 is repeated at predetermined intervals (in embodiments, these intervals are 60 - 90 seconds).

While the invention has been described with reference to the preferred embodiments depicted in the figures, it will be appreciated that various modifications are possible within the spirit or scope of the invention as defined in the following claims.

For example, whilst the present embodiments have been described in relation to an ammonia plant facility, the present invention is applicable to any other suitable form of industrial gas plant utilising, at least in part, renewable power. For example, the industrial gas plant or gas production facility may be a hydrogen or methanol production facility. Other alternatives will be apparent to one having ordinary skill in the art.

In the specification and claims, the term "industrial gas plant" is intended to refer to process plants which produce, or are involved in the production of industrial gases, commercial gases, medical gases, inorganic gases, organic gases, fuel gases and green fuel gases either in gaseous, liquified or compressed form.

For example, the term "industrial gas plant" may include process plants for the manufacture of gases such as those described in NACE class 20.11 and which includes, non-exhaustively: elemental gases; liquid or compressed air; refrigerant gases; mixed industrial gases; inert gases such as carbon dioxide; and isolating gases. Further, the term "industrial gas plant" may also include process plants for the manufacture of industrial gases in NACE class 20.15 such as ammonia, process plants for the extraction and/or manufacture of methane, ethane, butane or propane (NACE classes 06.20 and 19.20), and manufacture of gaseous fuels as defined by NACE class 35.21. The above has been described with respect to the European NACE system but is intended to cover equivalent classes under the North American classifications SIC and NAICS. In addition, the above list is non-limiting and non-exhaustive.

Whilst the above disclosure has focused on model predictive control models for the master facility controller 210, one of ordinary skill would be readily aware of variations which could be used. For example, other model-based controllers may be used with the present invention. Further, non-model-based control algorithms may be implemented.

In this specification, unless expressly otherwise indicated, the word "or" is used in the sense of an operator that returns a true value when either or both of the stated conditions are met, as opposed to the operator "exclusive or" which requires only that one of the conditions is met. The word "comprising" is used in the sense of "including" rather than to mean "consisting of".

In the discussion of embodiments of the present invention, the pressures given are absolute pressures unless otherwise stated.

All prior teachings above are hereby incorporated herein by reference. No acknowledgement of any prior published document herein should be taken to be an admission or representation that the teaching thereof was common general knowledge in Australia or elsewhere at the date thereof.

Where applicable, various embodiments provided by the present disclosure may be implemented using hardware, software, or combinations of hardware and software. Also, where applicable, the various hardware components and/or software components set forth herein may be combined into composite components comprising software, hardware, and/or both without departing from the spirit of the present disclosure. Where applicable, the various hardware components and/or software components set forth herein may be separated into sub-components comprising software, hardware, or both without departing from the scope of the present disclosure. In addition, where applicable, it is contemplated that software components may be implemented as hardware components and vice-versa.

Software, in accordance with the present disclosure, such as program code and/or data, may be stored on one or more computer readable mediums. It is also contemplated that software identified herein may be implemented using one or more general purpose or specific purpose computers and/or computer systems, networked and/or otherwise. Where applicable, the ordering of various steps described herein may be changed, combined into composite steps, and/or separated into sub-steps to provide features described herein.

While various operations have been described herein in terms of "modules", "units" or "components," it is noted that that terms are not limited to single units or functions. Moreover, functionality attributed to some of the modules or components described herein may be combined and attributed to fewer modules or components. Further still, while the present invention has been described with reference to specific examples, those examples are intended to be illustrative only, and are not intended to limit the invention. It will be apparent to those of ordinary skill in the art that changes, additions or deletions may be made to the disclosed embodiments without departing from the spirit and scope of the invention. For example, one or more portions of methods described above may be performed in a different order (or concurrently) and still achieve desirable results.

## Claims

1. A method of managing power in a power microgrid configured to supply electrical power to an industrial gas production facility comprising a facility controller and one or more industrial gas plants, the power microgrid comprising a power controller, one or more renewable power sources and one or more energy storage resources, the method being executed by at least one hardware processor and comprising:
a) generating, by the facility controller, time-dependent predicted power demand data representative of at least a predicted power demand of the industrial gas production facility for a predetermined time period;
b) utilizing, by the power controller, the predicted power demand data to generate control set point values for controlling a generated power output of the one or more renewable power sources and for controlling a flow of electrical power to or from the energy storage resources, the control set point values being selected to adjust the available power as a function of time for the predetermined time period to correspond to the demanded power for the predetermined time period; and
c) sending one or more control signals comprising the control set point values to the one or more renewable power sources and to the one or more energy storage resources.

2. A method according to claim 1, wherein the step of generating further comprises:
d) receiving, by the facility controller, time-dependent predicted available power data representative of at least the predicted available power from the power microgrid for the predetermined time period; and
e) generating the time-dependent predicted power demand data based at least in part on the time-dependent predicted available power data.

3. A method according to claim 2, wherein steps d) and e) are repeated at discrete time intervals for further predetermined time periods.

4. A method according to claim 2, wherein, prior to step d), the method further comprises:
f) generating, by the power controller, the time-dependent predicted available power data based on historical, real-time and/or predicted time-dependent environmental data associated with the one or more renewable power sources.

5. A method according to claim 4, wherein step f) further comprises generating the time-dependent predicted available power data based on a comparison between measured power generation and predicted power generation by the one or more renewable power sources for a previous predetermined time period.

6. A method according to any one of the preceding claims, further comprising, subsequent to step a):
g) sending the time-dependent power demand data to the power controller of the power microgrid.

7. A method according to claim 6, wherein step g) is repeated at discrete time intervals.

8. A method according to any one of the precediing claims, wherein the time-dependent power demand data is generated based on time-dependent operational characteristic data representative of one or more operational parameters of the one or more industrial gas plants and/or one or more constraints for the operational parameters of each industrial gas plant; and/or
wherein the one or more energy storage resources comprise one or more of: a battery energy storage system; a compressed air energy storage system; and a liquid air energy storage system; and/or
wherein the control set point values are selected to adjust the available power as a function of time for the predetermined time period to minimize the difference between the available power and the demanded power for the predetermined time period.

9. A system operable to manage power in a power microgrid configured to supply electrical power to an industrial gas production facility, the power microgrid comprising one or more renewable power sources and one or more energy storage resources, and the industrial gas production facility comprising one or more industrial gas plants, the system comprising a power controller associated with the power microgrid and a facility controller associated with the industrial gas production facility, the system comprising at least one hardware processor operable to perform the steps of:
a) generating, by the facility controller, time-dependent predicted power demand data representative of at least a predicted power demand of the industrial gas production facility for a predetermined time period;
b) utilizing, by the power controller, the predicted power demand data to generate control set point values for controlling a generated power output of the one or more renewable power sources and for controlling a flow of electrical power to or from the energy storage resources, the control set point values being selected to adjust the available power as a function of time for the predetermined time period to correspond to the demanded power for the predetermined time period; and
c) sending one or more control signals comprising the control set point values to the one or more renewable power sources and to the one or more energy storage resources.

10. A system according to claim 9, wherein the step of generating further comprises:
d) receiving, by the facility controller, time-dependent predicted available power data representative of at least the predicted available power from the power microgrid for the predetermined time period; and
e) generating the time-dependent predicted power demand data based at least in part on the time-dependent predicted available power data.

11. A system according to claim 10, wherein steps d) and e) are repeated at discrete time intervals for further predetermined time periods.

12. A system according to claim 10, wherein, prior to step d), the method further comprises:
f) generating, by the power controller, the time-dependent predicted available power data based on historical, real-time and/or predicted time-dependent environmental data associated with the one or more renewable power sources.

13. A system according to claim 12, wherein step f) further comprises generating the time-dependent predicted available power data based on a comparison between measured power generation and predicted power generation by the one or more renewable power sources for a previous predetermined time period.

14. A system according to any one of claims 9 to 13, further comprising, subsequent to step a):
g) sending the time-dependent power demand data to the power controller of the power microgrid.

15. A system according to claim 14, wherein step g) is repeated at discrete time intervals.

16. A system according to any one of claims 9 to 15, wherein the time-dependent power demand data is generated based on time-dependent operational characteristic data representative of one or more operational parameters of the one or more industrial gas plants and/or one or more constraints for the operational parameters of each industrial gas plant; and/or
wherein the one or more energy storage resources comprise one or more of: a battery energy storage system; a compressed air energy storage system; and a liquid air energy storage system.

17. A non-transitory computer readable storage medium storing a program of instructions executable by a machine to perform a method of managing power in a power microgrid configured to supply electrical power to an industrial gas production facility comprising a facility controller and one or more industrial gas plants, the power microgrid comprising a power controller, one or more renewable power sources and one or more energy storage resources, the method being executed by at least one hardware processor and comprising:
a) generating, by the facility controller, time-dependent predicted power demand data representative of at least a predicted power demand of the industrial gas production facility for a predetermined time period;
b) utilizing, by the power controller, the predicted power demand data to generate control set point values for controlling a generated power output of the one or more renewable power sources and for controlling a flow of electrical power to or from the energy storage resources, the control set point values being selected to adjust the available power as a function of time for the predetermined time period to correspond to the demanded power for the predetermined time period; and
c) sending one or more control signals comprising the control set point values to the one or more renewable power sources and to the one or more energy storage resources.
